# EUROPEAN PATENT APPLICATION

(11) **EP 4 746 660 A1**
(43) Date of publication of application: **20.05.2026**
(21) Application number: 24885992.8
(22) Date of filing: 29.08.2024
(51) Int. Cl.: H10K 59/80, H10K 77/10, G09F 9/30, G06F 1/16, H10K 59/131, H04M 1/02

(54) **DISPLAY MODULE INCLUDING MOLDING STRUCTURE, AND ELECTRONIC DEVICE COMPRISING SAME**

(30) Priority: 03.11.2023 KR 20230150904; 20.11.2023 KR 20230160364
(71) Applicant: Samsung Electronics Co., Ltd., Suwon-si, Gyeonggi-do 16677 (KR)
(72) Inventor: LEE, Seunghoon, Suwon-si Gyeonggi-do 16677 (KR); KIM, Jongkeun, Suwon-si Gyeonggi-do 16677 (KR); SON, Kwonho, Suwon-si Gyeonggi-do 16677 (KR); KIM, Sanghyun, Suwon-si Gyeonggi-do 16677 (KR); SEO, Dongwoo, Suwon-si Gyeonggi-do 16677 (KR); LEE, Ohhee, Suwon-si Gyeonggi-do 16677 (KR); HONG, Dongsool, Suwon-si Gyeonggi-do 16677 (KR)
(74) Representative: Nederlandsch Octrooibureau
(86) International application number: PCT/KR2024/012950
(87) International publication number: WO 2025/095312

(57) **Abstract**

In one embodiment, an electronic device comprises: a display module including a first housing, a second housing, a front part disposed to face a first direction, a first extension part that extends from one end of the front part so as to be bent in a second direction opposite to the first direction, and a second extension part that extends from the first extension part so as to be positioned in the rear direction of the front part; a molding structure encompassing at least the first extension part of the display module and including a conductive material; and a conductive member electrically connecting the molding structure to the first housing or the second housing. The surface of the molding structure in the first direction can be positioned at the same height as or higher than the outermost layer of the front part of the display module in the first direction.

## Description

### TECHNICAL FIELD

An embodiment of the present disclosure relates to a display module including a molding structure and an electronic device including the same.

### BACKGROUND ART

With the development of display-related technologies, electronic devices with flexible displays have been developed. A flexible display may be used in the form of a flat surface, and may also be deformed to be used in a specific shape. For example, an electronic device including a flexible display may be implemented as a foldable type which is folded or unfolded relative to at least one folding axis.

### DISCLOSURE OF THE INVENTION

### TECHNICAL SOLUTIONS

In an embodiment, an electronic device may include a first housing and a second housing foldably connected to each other, a display module including a front portion disposed on the first housing and the second housing and disposed in a first direction, a first extension extending from an end portion of the front portion and bent toward a second direction which is opposite to the first direction, and a second extension extending from the first extension and positioned in a rear direction of the front portion, a molding structure formed to surround at least the first extension of the display module and including a conductive material, and a conductive member electrically connecting the molding structure to the first housing or the second housing. A surface of the molding structure in the first direction may be positioned at a same height as or higher than an outermost layer of the front portion of the display module in the first direction.

In an embodiment, a display module applied to an electronic device may include a front portion disposed in a first direction, a first extension extending from an end portion of the front portion and bent toward a second direction which is opposite to the first direction, a second extension extending from the first extension and positioned in a rear direction of the front portion, and a molding structure formed to surround at least the first extension of the display module and including a conductive material. A surface of the molding structure in the first direction is positioned at a same height as or higher than an outermost layer of the front portion of the display module in the first direction.

In an embodiment, an electronic device may include a first housing and a second housing foldably connected to each other, a display module including a front portion disposed on the first housing and the second housing and disposed in a first direction, a first extension extending from an end portion of the front portion and bent toward a second direction which is opposite to the first direction, and a second extension extending from the first extension and positioned in a rear direction of the front portion, a molding structure formed to surround at least the first extension of the display module and including a conductive material, and a conductive member electrically connecting the molding structure to the first housing or the second housing. A surface of the molding structure in the first direction may be positioned at a same height as or higher than an outermost layer of the front portion of the display module in the first direction. The molding structure may be formed through a molding process using a mold having a shape which surrounds the first extension of the display module. In a process of folding the electronic device in an unfolded state, the molding structure may be elastically deformable. A width of the surface of the molding structure in the first direction may be less than a width of the surface in the second direction. When static electricity is generated in an edge area of the display module , the static electricity may be discharged to the first housing or the second housing through the display module, the molding structure, and the conductive member.

In an embodiment, when static electricity is generated in an edge area of a display module, the static electricity may be discharged to a first housing or a second housing through the display module, a molding structure, and a conductive member.

In an embodiment, a molding structure may protect a side surface of a display module.

The effects of a display module including a molding structure, and an electronic device including the same are not limited to the above-mentioned effects, and other unmentioned effects can be clearly understood from the above description by those having ordinary skill in the technical field to which the present disclosure pertains.

### BRIEF DESCRIPTION OF DRAWINGS

The above and other aspects, features, and advantages of certain embodiments of the present disclosure will be more apparent from the following detailed description, taken in conjunction with the accompanying drawings.
FIG. 1 is a block diagram of an electronic device in a network environment according to an embodiment.
FIG. 2A is a diagram illustrating an unfolded state of an electronic device according to an embodiment of the present disclosure.
FIG. 2B is a diagram illustrating a folded state of an electronic device according to an embodiment of the present disclosure.
FIG. 2C is a partial exploded perspective view of an electronic device according to an embodiment.
FIG. 3 is a rear view of a display module according to an embodiment.
FIG. 4 is a cross-sectional view of an electronic device in an unfolded state taken along line I-I of FIG. 2A according to an embodiment.
FIG. 5 is a cross-sectional view of an electronic device in a folded state at a position corresponding to FIG. 4 according to an embodiment.
FIG. 6 is a cross-sectional view of an electronic device according to an embodiment.
FIG. 7 is a cross-sectional view of an electronic device according to an embodiment.

### BEST MODE FOR CARRYING OUT THE INVENTION

Hereinafter, embodiments will be described in detail with reference to the accompanying drawings. When describing the embodiments with reference to the accompanying drawings, like reference numerals refer to like elements and a repeated description related thereto will be omitted.

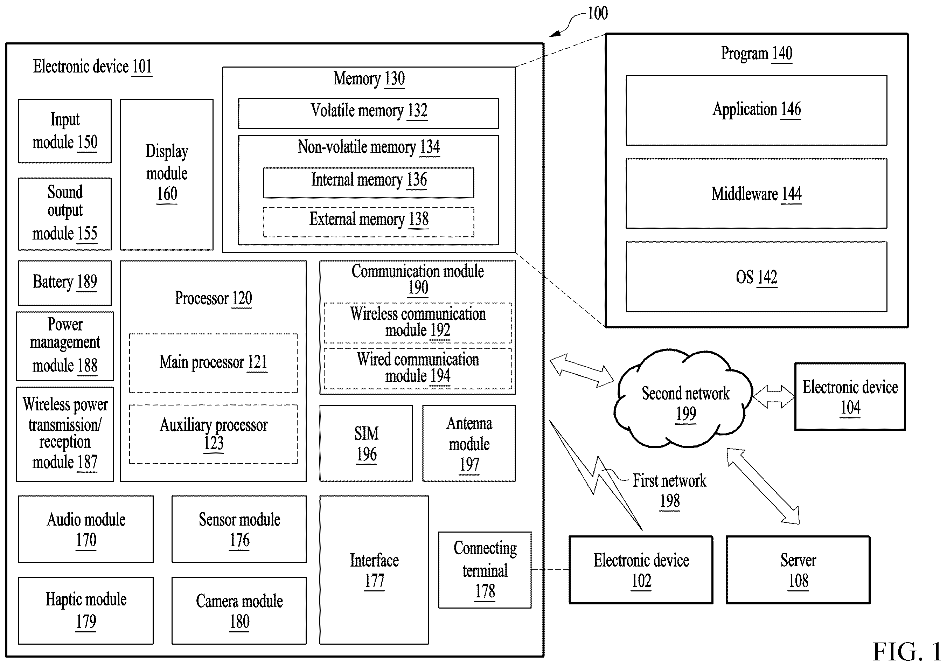

FIG. 1 is a block diagram illustrating an electronic device 101 in a network environment 100 according to an embodiment. Referring to FIG. 1, the electronic device 101 in the network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added to the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an ISP or a CP) may be implemented as a part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150 or output the sound via the sound output module 155 or an external electronic device (e.g., an electronic device 102) (e.g., a speaker or headphone) directly (wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, ISPs, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently from the processor 120 (e.g., the AP) and support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a fifth generation (5G) network, a next-generation communication network, the Internet, or a computer network (e.g., a LAN or a wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beamforming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an example embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an example embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed by one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, cloud computing, distributed computing, mobile edge computing (MEC), or client-server computing technology may be used, for example. The electronic device 101 may provide ultra low-latency services using, e.g., distributed computing or mobile edge computing. In one embodiment, the external electronic device 104 may include an Internet-of-things (IoT) device. The server 108 may be an intelligent server using machine learning and/or a neural network. According to an example embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to an embodiment disclosed herein may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic device is not limited to those described above.

It should be appreciated that the embodiment of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more instructions which are stored in a storage medium (e.g., internal memory 136 or external memory 138) which is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include code generated by a compiler or code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities, and some of the multiple entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

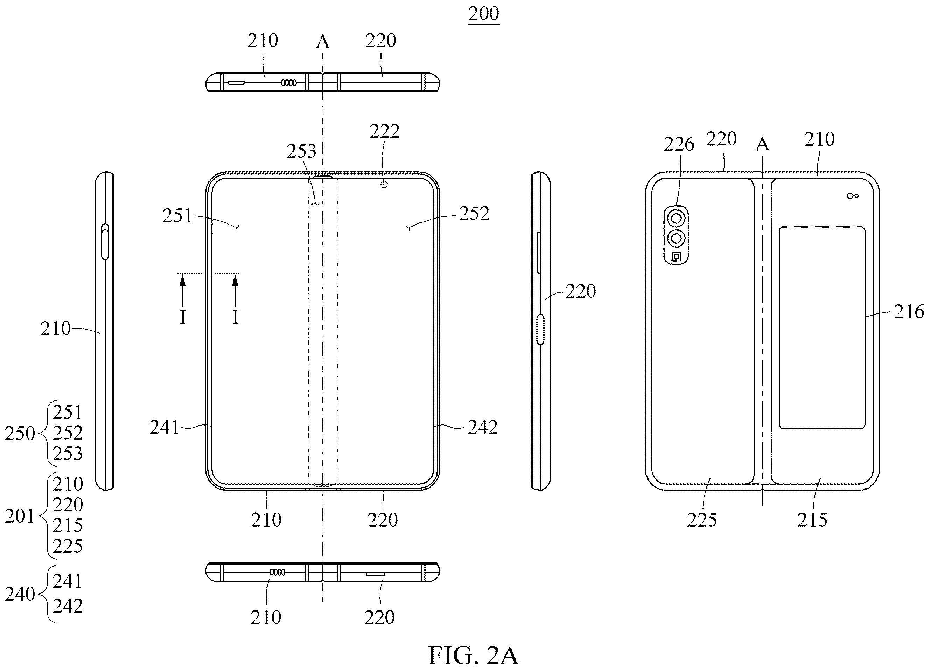

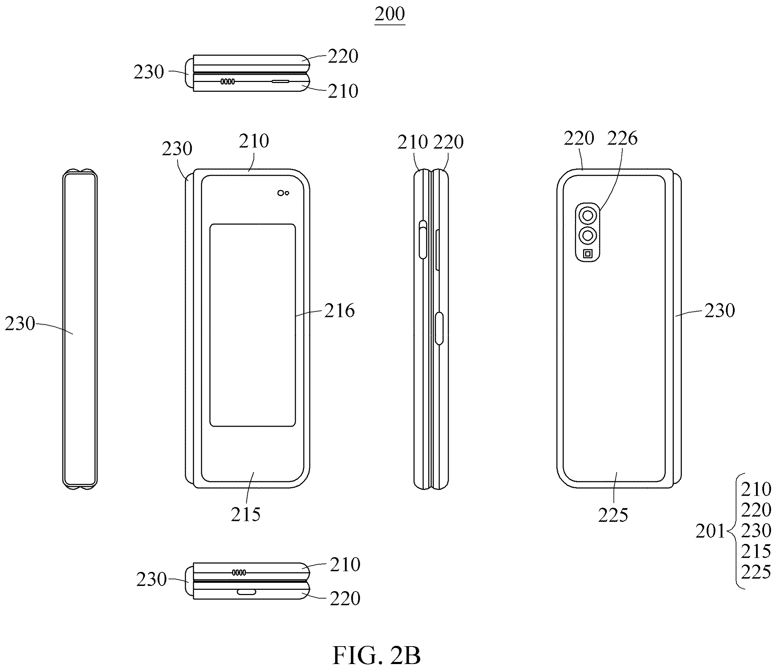

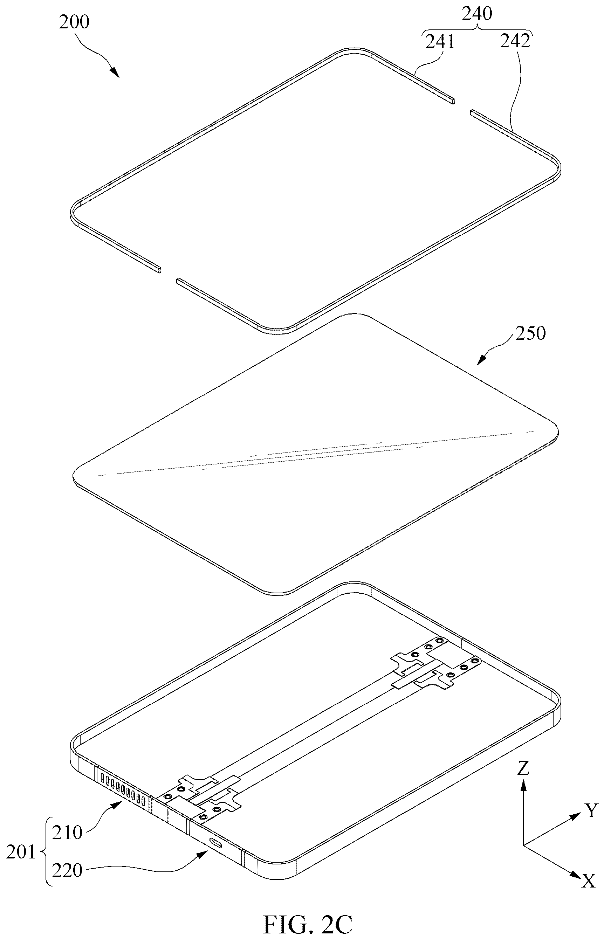

FIG. 2A is a diagram illustrating an unfolded state of an electronic device according to an embodiment of the present disclosure. FIG. 2B is a diagram illustrating a folded state of an electronic device according to an embodiment of the present disclosure. FIG. 2C is a partial exploded perspective view of an electronic device according to an embodiment.

An electronic device 200 of FIGS. 2A to 2C may be an example of the electronic device 101 illustrated in FIG. 1 and may be a foldable or bendable electronic device.

Referring to FIGS. 2A to 2C, in an embodiment, the electronic device 200 may include a foldable housing 201, an edge frame 240, and/or a display module 250 (e.g., the display module 160 of FIG. 1). The display module 250 may include a flexible or foldable display panel disposed in a space formed by the foldable housing 201. According to an embodiment, a surface on which the display module 250 is disposed (or a surface through which the display module 250 is viewed from the outside of the electronic device 200) may be defined as a front surface of the electronic device 200. In addition, a surface opposite to the front surface may be defined as a rear surface of the electronic device 200. Further, a surface surrounding a space between the front surface and the rear surface may be defined as a side surface of the electronic device 200.

In an embodiment, the foldable housing 201 may include a first housing 210, a second housing 220, a first rear cover 215, a second rear cover 225, and/or a hinge structure 230. For example, the hinge structure 230 may include a hinge cover which covers a foldable portion of the foldable housing 201. The foldable housing 201 of the electronic device 200 is not limited to the shape and combination shown in FIGS. 2A and 2B, and may be implemented in a different shape or a different combination of components. For example, in an embodiment, the first housing 210 and the first rear cover 215 may be integrally formed, and the second housing 220 and the second rear cover 225 may be integrally formed.

In an embodiment, the first housing 210 may be connected to the hinge structure 230 and may include a first surface oriented in a first direction and a second surface oriented in a second direction which is opposite to the first direction. The second housing 220 may be connected to the hinge structure 230 and may include a third surface oriented in a third direction and a fourth surface oriented in a fourth direction which is opposite to the third direction. The second housing 220 may rotate with respect to the first housing 210 about the hinge structure 230. A state of the electronic device 200 may be changed to a folded state (or status) or an unfolded state.

In an embodiment, in a fully folded state of the electronic device 200, the first surface may face the third surface, and in a fully unfolded state of the electronic device 200, the third direction may be substantially the same as the first direction.

In an embodiment, the first housing 210 and the second housing 220 may be foldably connected to each other. The first housing 210 and the second housing 220 may be disposed on both sides with respect to a folding axis A and may be generally symmetrical with respect to the folding axis A. As described below, an angle or distance between the first housing 210 and the second housing 220 may vary depending on whether the state of the electronic device 200 is the unfolded state, the folded state, or a partially unfolded (or partially folded) intermediate state. According to an embodiment, the second housing 220 may include a sensor area 222 in which various sensors are disposed. For example, various sensors may be positioned on the rear surface of the display module 250 in the sensor area 222. According to an embodiment, the first housing 210 may include a sensor area (not illustrated) in which at least one sensor is disposed.

In an embodiment, the first housing 210 and the second housing 220 may form a recess which accommodates the display module 250. In an embodiment, components embedded in the electronic device 200 to perform various functions may be exposed to the front surface of the electronic device 200 through the sensor area 222 or one or more openings provided in the sensor area 222. In an embodiment, the components may include various types of sensors. The sensors may include, for example, at least one of a front camera, a receiver, or a proximity sensor. According to an embodiment, the sensor area 222 may be omitted from the second housing 220 or may be formed at a position different from that illustrated in the drawings.

In an embodiment, at least a portion of the first housing 210 and the second housing 220 may include a metal material or a non-metal material having a selected magnitude of rigidity to support the display module 250. For example, at least a portion formed of the metal material may provide a ground plane of the electronic device 200 and may be electrically connected to a ground line formed on a PCB disposed inside the foldable housing 201.

In an embodiment, the first rear cover 215 may be disposed on one side of the folding axis A on the rear surface of the electronic device 200. For example, the first rear cover 215 may have a substantially rectangular periphery, and the periphery may be enclosed by the first housing 210. For example, the second rear cover 225 may be disposed on the other side of the folding axis A on the rear surface of the electronic device 200. For example, the periphery of the second rear cover 225 may be enclosed by the second housing 220.

In an embodiment, the first rear cover 215 and the second rear cover 225 may have substantially symmetrical shapes with respect to the folding axis A. However, the first rear cover 215 and the second rear cover 225 do not necessarily have mutually symmetrical shapes, and in an embodiment, the electronic device 200 may include the first rear cover 215 and the second rear cover 225 having various shapes. In an embodiment, the first rear cover 215 may be integrally formed with the first housing 210, and the second rear cover 225 may be integrally formed with the second housing 220.

In an embodiment, the first rear cover 215, the second rear cover 225, the first housing 210, and the second housing 220 may form a space in which various components (e.g., a PCB or a battery) of the electronic device 200 are disposed. In an embodiment, one or more components may be disposed or visually exposed on the rear surface of the electronic device 200. For example, at least a portion of a sub-display may be visually exposed through a first rear area 216 of the first rear cover 215. In an embodiment, one or more components or sensors may be visually exposed through a second rear area 226 of the second rear cover 225. In an embodiment, the sensor may include a proximity sensor and/or a rear camera.

In an embodiment, the front camera visually exposed on the front surface of the electronic device 200 through one or more openings provided in the sensor area 222 or the rear camera visually exposed through the second rear area 226 of the second rear cover 225 may include one or more lenses, an image sensor, and/or an image signal processor. A flash may include, for example, a light-emitting diode (LED) or a xenon lamp. In an embodiment, two or more lenses (e.g., IR cameras, wide-angle and telephoto lenses) and image sensors may be disposed on one surface of the electronic device 200.

In an embodiment, referring to FIG. 2B, the hinge cover may be disposed between the first housing 210 and the second housing 220 to cover an internal component (e.g., the hinge structure 230). According to an embodiment, depending on the state (e.g., the unfolded state, the intermediate state, or the folded state) of the electronic device 200, the hinge structure 230 may be covered by a portion of the first housing 210 and the second housing 220 or may be exposed to the outside.

In an embodiment, as illustrated in FIG. 2A, when the electronic device 200 is in the unfolded state (e.g., the fully unfolded state), the hinge structure 230 may be covered by the first housing 210 and the second housing 220 and may not be exposed. In an embodiment, as illustrated in FIG. 2B, when the electronic device 200 is in the folded state (e.g., the fully folded state), the hinge structure 230 may be exposed to the outside between the first housing 210 and the second housing 220. In an embodiment, in the case of the intermediate state folded with a certain angle between the first housing 210 and the second housing 220, the hinge structure 230 may be partially exposed to the outside between the first housing 210 and the second housing 220. However, the area exposed in this example may be smaller than that in the fully folded state. In an embodiment, the hinge structure 230 may include a curved surface.

In an embodiment, the edge frame 240 may be connected to the foldable housing 201 to surround at least a portion of an edge area of the display module 250. For example, the edge frame 240 may surround the front surface and/or the side surface of the edge area of the display module 250. For example, the edge frame 240 may include a first edge frame 241 and a second edge frame 242. The first edge frame 241 and the second edge frame 242 may be respectively connected to the first housing 210 and the second housing 220 to surround at least a portion of the edge area of the display module 250. However, this is an example, and the first edge frame 241 and the second edge frame 242 may be integrally formed with the first housing 210 and the second housing 220.

In an embodiment, the display module 250 may be disposed in a space formed by the foldable 20 housing 201. For example, the display module 250 may be placed on a recess formed by the foldable housing 201 and may be visible from the outside through the front surface of the electronic device 200. For example, the display module 250 may form most of the front surface of the electronic device 200. For example, the front surface of the electronic device 200 may include the display module 250, a partial area of the first housing 210 adjacent to the display module 250, and a partial area of the second housing 220. For example, the rear surface of the electronic device 200 may include the first rear cover 215, a partial area of the first housing 210 adjacent to the first rear cover 215, the second rear cover 225, and a partial area of the second housing 220 adjacent to the second rear cover 225.

In an embodiment, the display module 250 may refer to a display in which at least a partial area is deformable into a planar surface or a curved surface. According to an embodiment, the display module 250 may include a folding area 253, a first area 251 disposed on one side of the folding area 253 (e.g., on the left side of the folding area 253 illustrated in FIG. 2A), and a second area 252 disposed on the other side of the folding area 253 (e.g., on the right side of the folding area 253 illustrated in FIG. 2A). However, the area division of the display module 250 illustrated in FIG. 2A is an example, and the display module 250 may be divided into a plurality of areas (e.g., four or more areas, or two areas) depending on the structure or function. For example, in the embodiment illustrated in FIG. 2A, the area of the display module 250 may be divided based on the folding area 253 extending in parallel to the folding axis A. However, in an embodiment, the area may be divided based on another folding axis (e.g., a folding axis parallel to a width direction of the electronic device) of the display module 250.

In an embodiment, the display module 250 may be coupled to or disposed adjacent to a touch panel in which a touch sensing circuit and a pressure sensor configured to measure the intensity (pressure) of a touch are provided. For example, the display module 250 may be an example of the touch panel and may be coupled to or disposed adjacent to a touch panel for detecting an electromagnetic resonance (EMR) stylus pen.

In an embodiment, the first area 251 and the second area 252 may generally have symmetrical shapes with respect to the folding area 253. However, unlike the first area 251, the second area 252 may include a notch cut according to the presence of the sensor area 222, but may be symmetrical to the first area 251 in the other areas. For example, the first area 251 and the second area 252 may include mutually symmetrical portions and mutually asymmetrical portions.

In an embodiment, an edge thickness of each of the first area 251 and the second area 252 may be different from an edge thickness of the folding area 253. The edge thickness of the folding area 253 may be less than those of the first area 251 and the second area 252. For example, the first area 251 and the second area 252 may be asymmetrical in terms of thickness when the first area 251 and the second area 252 are cross-sectionally viewed. For example, an edge of the first area 251 may be formed to have a first radius of curvature and an edge of the second area 252 may be formed to have a second radius of curvature which is different from the first radius of curvature. In an embodiment, the first area 251 and the second area 252 may be symmetrical in terms of thickness when the first area 251 and the second area 252 are cross-sectionally viewed.

Hereinafter, respective areas of the display module 250 and operations of the first housing 210 and the second housing 220 depending on the state (e.g., the folded state, the unfolded state, or the intermediate state) of the electronic device 200 are described.

In an embodiment, when the electronic device 200 is in the unfolded state (e.g., FIG. 2A), the first housing 210 and the second housing 220 may be disposed to face the same direction with an angle of about 180 degrees. The surface of the first area 251 and the surface of the second area 252 of the display module 250 may face the same direction (e.g., a front direction of an electronic device) with an angle of 180 degrees. The folding area 253 may form the same plane together with the first area 251 and the second area 252.

In an embodiment, when the electronic device 200 is in the folded state (e.g., FIG. 2B), the first housing 210 and the second housing 220 may be disposed to face each other. The surface of the first area 251 and the surface of the second area 252 of the display module 250 may face each other and may form a narrow angle (e.g., an angle between 0 degrees to 10 degrees). At least a portion of the folding area 253 may form a curved surface having a predetermined curvature.

In an embodiment, when the electronic device 200 is in the intermediate state, the first housing 210 and the second housing 220 may be disposed to form a certain angle therebetween. The surface of the first area 251 and the surface of the second area 252 of the display module 250 may form an angle greater than that in the folded state and less than that in the unfolded state. At least a portion of the folding area 253 may include a curved surface having a predetermined curvature, and the curvature may be less than that in the folded state.

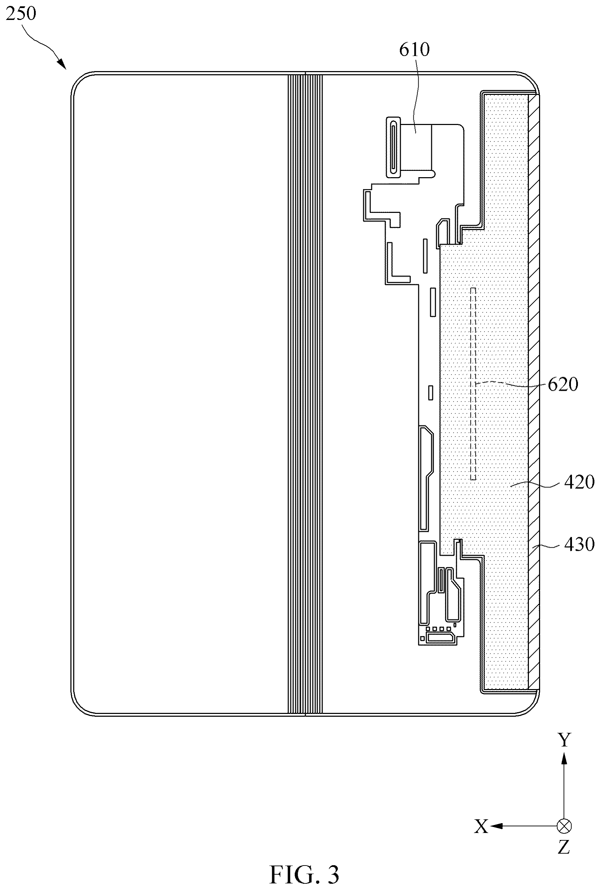

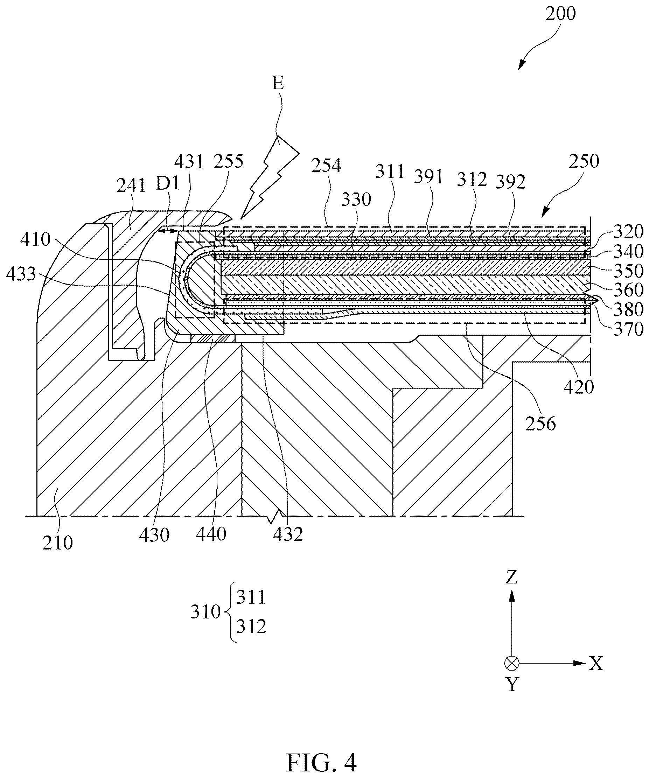

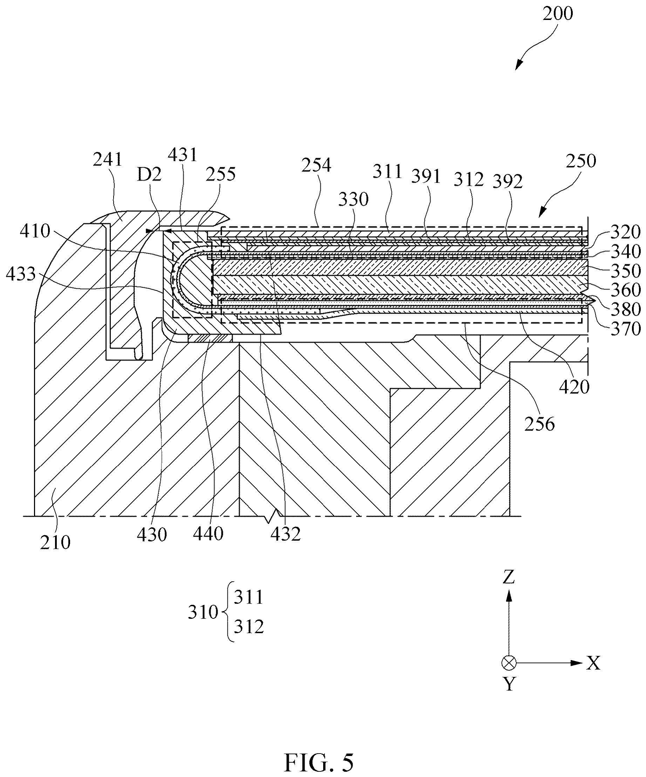

FIG. 3 is a rear view of a display module according to an embodiment. FIG. 4 is a cross-sectional view of an electronic device in an unfolded state taken along line I-I of FIG. 2A according to an embodiment. FIG. 5 is a cross-sectional view of an electronic device in a folded state at a position corresponding to FIG. 4 according to an embodiment.

Referring to FIGS. 3 to 5, in an embodiment, the display module 250 may include various layers stacked on each other and/or electronic components electrically connected to each other. The display module 250 may include a front portion 254, a first extension 255, and a second extension 256. The front portion 254 may refer to a portion disposed in a first direction (e.g., the +Z direction). For example, a window layer 310, a polarizing layer 320, a portion of a display panel 330, and/or a third protective layer 340 to be described below may be disposed on the front portion 254. The first extension 255 may be a portion extending from an end portion (e.g., an end portion in the -X direction) of the front portion 254 in a second direction (e.g., the -Z direction which is opposite to a first direction (e.g., the +Z direction). For example, the first extension 255 may be disposed to substantially face a lateral direction (e.g., the -X direction) of an electronic device (e.g., the electronic device 200 of FIG. 2C). For example, a portion of the display panel 330, a bending protection member 410, and/or a molding structure 430 to be described below may be disposed on the first extension 255. The second extension 256 may extend from the first extension 255 and may be positioned in a rear direction (e.g., the -Z direction) of the front portion 254. For example, the second extension 256 may be positioned substantially parallel to the front portion 254 in the rear direction (e.g., the -Z direction) of the front portion 254. For example, a fourth protective layer 370, a portion of the display panel 330, and/or a cover member 420 to be described below may be disposed on the second extension 256. The second extension 256 of the display module 250 may be electrically connected to a flexible PCB (FPCB) 610. For example, a control circuit 620 may be disposed on the second extension 256. For example, the control circuit 620 may be disposed on the second extension 256 in a chip on panel or plastic (COP) manner. For example, the control circuit 620 may include a display driver IC (DDI) or a touch display driver IC (TDDI).

In an embodiment, the display module 250 may include the window layer 310, the polarizing layer 320, the display panel 330, the third protective layer 340, a composite sheet 350, a conductive plate 360, the fourth protective layer 370, a spacer 380, a bending protection member 410, the cover member 420, the FPCB 610, the control circuit 620, the molding structure 430, and/or a conductive member 440.

In an embodiment, the window layer 310 may include a first protective layer 311 and a second protective layer 312. For example, the first protective layer 311 may include a polymer layer. For example, the first protective layer 311 may include a polyethylene terephthalate (PET) material or a polyimide material. For example, the second protective layer 312 may include a glass layer. For example, the second protective layer 312 may include ultra-thin glass (UTG). For example, the second protective layer 312 may be stacked on a rear surface (e.g., the surface in the -Z direction) of the first protective layer 311 by a first bonding layer 391.

In an embodiment, the polarizing layer 320 may be stacked on a rear surface (e.g., the surface in the -Z direction) of the window layer 310. For example, the polarizing layer 320 may be stacked on a rear surface (e.g., the surface in the -Z direction) of the second protective layer 312 by a second bonding layer 392. For example, the polarizing layer 320 may include a polarizing film.

In an embodiment, the display panel 330 may be configured to visually display information. The display panel 330 may be stacked on a rear surface (e.g., the surface in the -Z direction) of the polarizing layer 320. The display panel 330 may be positioned across the front portion 254, the first extension 255, and the second extension 256. For example, the display panel 330 positioned on the front portion 254 may be positioned to face a first direction (e.g., the +Z direction). The display panel 330 positioned at the first extension 255 may extend from an end portion (e.g., the end portion in the -X direction) of the front portion 254 and may be bent toward a second direction (e.g., the -Z direction) which is opposite to the first direction (e.g., the +Z direction). For example, the display panel 330 positioned at the first extension 255 may be disposed to substantially face a lateral direction (e.g., the -X direction) of an electronic device (e.g., the electronic device 200 of FIG. 2C). The display panel 330 positioned at the second extension 256 may extend from the first extension 255 and may be positioned in the rear direction (e.g., the -Z direction) of the front portion 254. For example, the display panel 330 positioned at the second extension 256 may be positioned substantially parallel to the display panel 330 positioned at the front portion 254.

In an embodiment, the third protective layer 340 may be attached to at least a partial area of the display panel 330. For example, the third protective layer 340 may be stacked on the rear surface (e.g., the surface in the -Z direction) of the front portion 254 of the display panel 330. For example, the third protective layer 340 may be a component for protecting a plurality of elements (e.g., a thin film transistor (TFT)) of the display panel 330. For example, the third protective layer 340 may be a component for fixing and/or protecting the display panel 330 while forming an organic light-emitting diode (OLED).

In an embodiment, the composite sheet 350 may be stacked on the rear surface (e.g., the surface in the -Z direction) of the third protective layer 340. For example, the composite sheet 350 may include at least one polymer layer (e.g., a light-shielding layer and/or a buffer layer) and/or at least one functional member (e.g., a heat dissipation sheet).

In an embodiment, the conductive plate 360 may be stacked on the rear surface (e.g., the surface in the -Z direction) of the composite sheet 350. The conductive plate 360 may enhance the rigidity of the display panel 330. The conductive plate 360 may shield surrounding noise. The conductive plate 360 may dissipate and/or disperse heat generated in the surroundings. For example, the conductive plate 360 include at least one of steel use stainless (SUS) (e.g., stainless steel (STS)), Cu, Al, or CLAD (e.g., a stacking member in which SUS and Al are alternately arranged). However, this is an example, and the conductive plate 360 may include other alloy materials. The conductive plate 360 may include a lattice including a plurality of openings and/or slits at a position corresponding to a hinge structure (e.g., the hinge structure 230 of FIG. 2B) for a bending motion of the display module 250.

In an embodiment, the fourth protective layer 370 may be attached to at least a partial area of the display panel 330. For example, the fourth protective layer 370 may be stacked on the rear surface (e.g., the surface in the +Z direction) of the second extension 256 of the display panel 330. For example, the fourth protective layer 370 may be a component for protecting a plurality of elements (e.g., a TFT) of the display panel 330. For example, the fourth protective layer 370 may be a component for fixing and/or protecting the display panel 330 while forming an OLED.

In an embodiment, the spacer 380 may be disposed between the conductive plate 360 and the fourth protective layer 370. For example, the spacer 380 may be bonded to a surface (e.g., the surface in the -Z direction) of the conductive plate 360 facing the second direction and a surface (e.g., the surface in the +Z direction) of the fourth protective layer 370 facing the first direction. For example, the spacer 380 may include a polymer material.

In an embodiment, the bending protection member 410 may be configured to cover the outer surface of the first extension 255. For example, the bending protection member 410 may cover at least a portion of the display panel 330 positioned at the first extension 255 from the outside. The bending protection member 410 may be substantially positioned across the front portion 254, the first extension 255, and the second extension 256. For example, an end portion of the bending protection member 410 may extend to the front portion 254, and the other end portion of the bending protection member 410 may extend to the second extension 256.

In an embodiment, the cover member 420 may cover a component positioned at the second extension 256 from the rear direction (e.g., the -Z direction). For example, the cover member 420 may cover the bending protection member 410 positioned at the second extension 256 and the display panel 330 positioned at the second extension 256 from the rear direction (e.g., the -Z direction).

In an embodiment, in the display module 250, layers may slip relative to each other to respond to a folding motion of an electronic device (e.g., the electronic device 200 of FIGS. 2A and 2B). For example, comparing FIG. 4 where the electronic device 200 is unfolded to FIG. 5 where the electronic device 200 is folded, among layers of the display module 250, as a layer is positioned closer to the front direction (e.g., the +Z direction), the layer may slip more in a width direction (e.g., the -X direction) toward the outside. For example, in a process of folding the electronic device 200 from the unfolded state, an end portion of a layer positioned relatively in the front direction (e.g., the +Z direction) in the display module 250 may protrude more in the outer direction (e.g., the -X direction) compared to a layer positioned relatively in the rear direction (e.g., the -Z direction).

Meanwhile, the structure of the display module 250 described above is an example and is not limited thereto. For example, the order in which the components of the display module 250 are stacked is not limited to the order described above, and the components may be stacked in a different order. For example, the display module 250 according to an embodiment may not include some of the components described above. For example, the display module 250 according to an embodiment may further include various components other than the components described above.

Hereinafter, referring to FIGS. 3 to 5, the molding structure 430 and the conductive member 440 according to an embodiment are described.

In an embodiment, the molding structure 430 may be formed to surround at least a portion of the display module 250. For example, the molding structure 430 may be formed to surround at least the first extension 255 of the display module 250. The molding structure 430 may be formed through a molding process and/or a laser direct structuring (LDS) process. For example, the molding structure 430 may be formed using a mold having a shape which surrounds at least the first extension 255 of the display module 250. Through the molding process, the molding structure 430 may be formed to fill a space adjacent to the first extension 255 of the display module 250. For example, the molding structure 430 may surround a portion in which the first extension 255 is connected to the front portion 254 and/or a portion in which the first extension 255 is connected to the second extension 256 while surrounding the first extension 255 of the display module 250.

In an embodiment, a first surface 431 of the molding structure 430 in the first direction (e.g., the +Z direction) may be positioned at the same height as or higher than an outermost layer of the front portion 254 of the display module 250 in the first direction (e.g., the +Z direction). For example, as shown in FIG. 4, the first surface 431 of the molding structure 430 in the first direction (e.g., the +Z direction) may be positioned on substantially the same plane as the outermost layer of the front portion 254 of the display module 250 in the first direction (e.g., the +Z direction). The outermost layer of the front portion 254 of the display module 250 in the first direction (e.g., the +Z direction) may be, for example, the first protective layer 311. However, this is an example, and the outermost layer of the front portion 254 of the display module 250 in the first direction (e.g., the +Z direction) is not limited thereto.

In an embodiment, the thickness (e.g., the thickness in the Z direction) of the molding structure 430 may be greater than the thickness (e.g., the thickness in the Z direction) of the first extension 255 of the display module 250. For example, the first surface 431 of the molding structure 430 in the first direction (e.g., the +Z direction) may be positioned on substantially the same plane as the outermost layer (e.g., the first protective layer 311) of the front portion 254 of the display module 250 in the first direction (e.g., the +Z direction), and a second surface 432 of the molding structure 430 in a second direction (e.g., the -Z direction) may protrude more in the second direction (e.g., the -Z direction) compared to an outermost layer (e.g., the cover member 420) of the second extension 256 of the display module 250 in the second direction (e.g., the -Z direction).

In an embodiment, the cross-section of the molding structure 430 may include a trapezoidal or parallelogram shape. For example, while the electronic device 200 (or the display module 250) is unfolded, the width of the first surface 431 of the molding structure 430 which is disposed in the first direction (e.g., the +Z direction) may be less than the width of the second surface 432 of the molding structure 430 which is disposed in the second direction (e.g., the -Z direction). For example, as shown in FIG. 4, while the electronic device 200 is unfolded, a side surface 433 (e.g., a side surface in the -X direction) of the molding structure 430 may be inclined with respect to the first direction (e.g., the +Z direction). For example, while the electronic device 200 is unfolded, the side surface 433 of the molding structure 430 may be inclined more inward (e.g., toward the +X direction) as the side surface 433 faces the first direction (e.g., the +Z direction). However, the shape of the molding structure 430 described above is an example and is not limited thereto. The shape of the molding structure 430 described above may also be understood as the shape of a mold for forming the molding structure 430.

In an embodiment, the molding structure 430 may include an elastically deformable material. For example, the molding structure 430 may be elastically deformable. The molding structure 430 may be conductive. For example, the molding structure 430 may include a conductive material. For example, the molding structure 430 may be formed using a molding material (e.g., a material including urethane and/or acrylic) to which a conductive additive is added. However, this is an example, and the material of the the molding structure 430 is not limited thereto.

In an embodiment, the conductive member 440 may electrically connect the molding structure 430 to the first housing 210 (or the second housing 220). For example, the conductive member 440 may include conductive adhesive tape and/or a conductive gasket. The conductive member 440 may be attached to the second surface 432 of the molding structure 430 which is in the second direction (e.g., the -Z direction). For example, the conductive member 440 may bond the second surface 432 of the molding structure 430 in the second direction (e.g., the -Z direction) to a surface of the first housing 210 (or the second housing 220) in the first direction (e.g., the +Z direction). For example, an outer shell of the conductive member 440 may be made of conductive fiber or metal foil. For example, the conductive member 440 may be formed of an elastically deformable material. However, this is an example, and the type and/or the position of the conductive member 440 are not limited thereto.

In an embodiment, when static electricity E is generated at an edge area of the display module 250, the static electricity E may be discharged to the first housing 210 (or the second housing 220) through the display module 250, the molding structure 430, and the conductive member 440. According to the structure described above, since the static electricity E is discharged to the first housing 210 (or the second housing 220) without staying in the display module 250, the display module 250 may be protected from the static electricity E.

In an embodiment, in the process of folding the electronic device 200 from the unfolded state, the molding structure 430 may be elastically deformed. For example, in the process of folding the electronic device 200 from the unfolded state, the molding structure 430 may be elastically deformed in response to a slip motion of the display module 250. For example, while the electronic device 200 is unfolded, the side surface 433 of the molding structure 430 may be positioned to be inclined with respect to the first direction (e.g., the +Z direction), and while the electronic device 200 is folded, the side surface 433 of the molding structure 430 may be elastically deformed to be substantially parallel to the first direction (e.g., the +Z direction). For example, a widthwise distance D1 between the first edge frame 241 and an end portion of the side surface 433 of the molding structure 430 in the first direction (e.g., the +Z direction) when the electronic device 200 is in the folded state may be less than a widthwise distance D2 between the first edge frame 241 and the end portion of the side surface 433 of the molding structure 430 in the first direction (e.g., the +Z direction) when the electronic device 200 is in the unfolded state.

In an embodiment, according to the structures of the molding structure 430 and the conductive member 440 described above, the static electricity E generated in the display module 250 may be discharged to the first housing 210 (or the second housing 220), thereby preventing or reducing damage to the display module 250 due to the static electricity E. Since the molding structure 430 surrounds an outer area of the display module 250, the display module 250 may be cushioned and protected from an external impact by the molding structure 430. Due to the cushioning of the molding structure 430, even if the distance between the display module 250 and the first edge frame 241 (or the second edge frame 242) is designed to be closer, damage to the display module 250 caused by contact between the display module 250 and the first edge frame 241 (or the second edge frame 242) due to the external impact may be prevented or reduced. Since the first surface 431 of the molding structure 430 in the first direction (e.g., the +Z direction) is positioned on substantially the same plane as the outermost layer (e.g., the first protective layer 311) of the front portion 254 of the display module 250 in the first direction (e.g., the +Z direction), a gap in the width direction (e.g., the Z direction) between the display module 250 and the first edge frame 241 may be reduced.

Meanwhile, although the molding structure 430 and the conductive member 440 are described to be positioned adjacent to the first housing 210 and the first edge frame 241, this is an example, and it is apparent to those skilled in the art that the molding structure 430 and the conductive member 440 are positioned adjacent to the second housing 220 and the second edge frame 242. For example, in an embodiment, when the first extension 255 of the display module 250 is positioned on the side of the second housing 220, the molding structure 430 and the conductive member 440 may be positioned adjacent to the second housing 220 and the second edge frame 242.

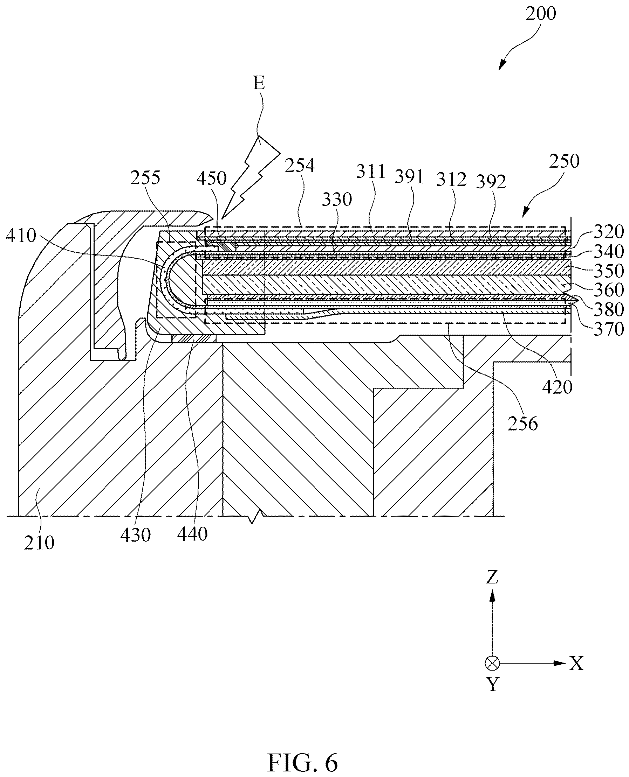

FIG. 6 is a cross-sectional view of an electronic device according to an embodiment.

Referring to FIG. 6, in an embodiment, the display module 250 may include the front portion 254, the first extension 255, and the second extension 256. The display module 250 may include the first protective layer 311, the second protective layer 312, the polarizing layer 320, the display panel 330, the third protective layer 340, the composite sheet 350, the conductive plate 360, the fourth protective layer 370, the spacer 380, the bending protection member 410, the cover member 420, the FPCB 610, the control circuit 620, the molding structure 430, the conductive member 440, and/or a bonding member 450. In describing the electronic device according to FIG. 6, a detailed description of a component which is substantially the same as the component described with reference to FIGS. 3 to 5 is omitted.

In an embodiment, the bonding member 450 may fill a space between the front portion 254 of the display module 250 and the first extension 255. After the space between the front portion 254 of the display module 250 and the first extension 255 is filled with the bonding member 450, a molding process to form the molding structure 430 may be performed. The bonding member 450 may be non-conductive. For example, bonding member 450 may include a non-conductive material. When the static electricity E is generated in an edge area of the display module 250, the static electricity E may be discharged to the first housing 210 (or a second housing (e.g., the second housing 220 of FIG. 2C)) through the display module 250, the molding structure 430, and the conductive member 440. While the static electricity E is discharged, since the bonding member 450 which is non-conductive fills between the front portion 254 of the display module 250 and the first extension 255, the static electricity E flowing back into the display module 250 may be prevented or reduced.

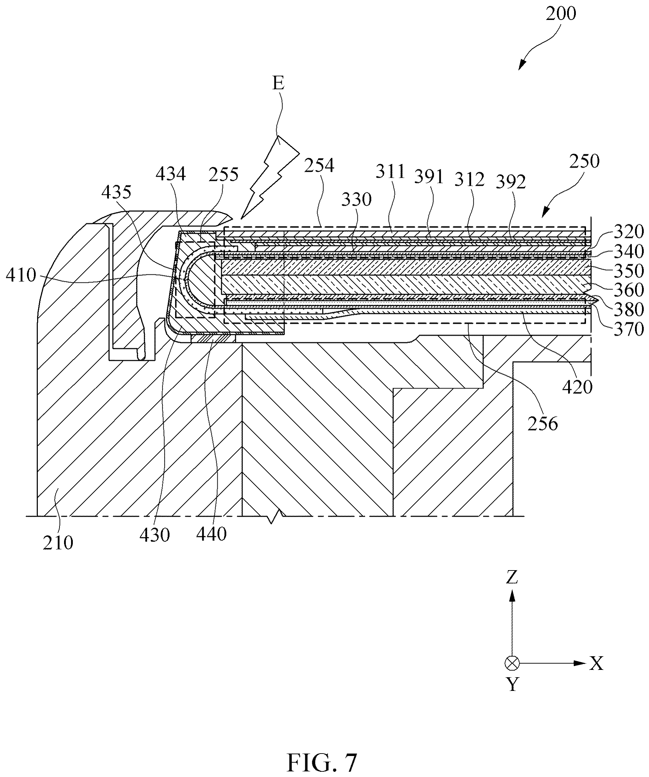

FIG. 7 is a cross-sectional view of an electronic device according to an embodiment.

Referring to FIG. 7, in an embodiment, the display module 250 may include the front portion 254, the first extension 255, and the second extension 256. The display module 250 may include the first protective layer 311, the second protective layer 312, the polarizing layer 320, the display panel 330, the third protective layer 340, the composite sheet 350, the conductive plate 360, the fourth protective layer 370, the spacer 380, the bending protection member 410, the cover member 420, the FPCB 610, the control circuit 620, the molding structure 430, and/or the conductive member 440. In describing the electronic device according to FIG. 7, a detailed description of a component which is substantially the same as the component described with reference to FIGS. 3 to 5 is omitted.

In an embodiment, the molding structure 430 may include a molding body 434 and a conductive coat 435. The molding body 434 may be a portion formed through a molding process and/or an LDS process. The molding body 434 may be non-conductive. For example, the molding body 434 may include a non-conductive material. For example, the molding body 434 may be formed of a non-conductive molding material. The conductive coat 435 may be coated or plated onto the outer surface of the molding body 434. The conductive coat 435 may be conductive. For example, the conductive coat 435 may be formed on a surface of the molding body 434 in the first direction (e.g., the +Z direction), a side surface, and a surface facing the second direction (e.g., the -Z direction). When the static electricity E is generated in an edge area of the display module 250, the static electricity E may be discharged to the first housing 210 (or a second housing (e.g., the second housing 220 of FIG. 2C)) through the display module 250, the conductive coat 435 of the molding structure 430, and the conductive member 440. While the static electricity E is discharged, since the molding body 434 is non-conductive, the static electricity E may flow along the outer surface of the molding structure 430 and may be discharged to the first housing 210 (or a second housing (e.g., the second housing 220 of FIG. 2C)) along the conductive coat 435. In this discharge process, since the molding body 434 is non-conductive, the static electricity E flowing back into the display module 250 may be prevented or reduced.

In an embodiment, the electronic device 200 may include the first housing 210 and the second housing 220 foldably connected to each other, the display module including the front portion 254 disposed on the first housing and the second housing and disposed in the first direction, the first extension 255 extending from an end portion of the front portion 254 and bent toward the second direction which is opposite to the first direction, and the second extension 256 extending from the first extension 255 and positioned in the rear direction of the front portion, the molding structure 430 formed to surround at least the first extension 255 of the display module 250 and including a conductive material, and the conductive member 440 electrically connecting the molding structure 430 to the first housing 210 or the second housing 220. The surface of the molding structure 430 in the first direction may be positioned at the same height as or higher than the outermost layer of the front portion 254 of the display module 250 in the first direction.

In an embodiment, the molding structure 430 may be formed to fill a space adjacent to the first extension 255 of the display module 250.

In an embodiment, the molding structure 430 may be formed through a molding process using a mold having a shape which surrounds the first extension 255 of the display module 250.

In an embodiment, in a process of folding the electronic device 200 in an unfolded state, the molding structure 430 may be elastically deformable.

In an embodiment, while the electronic device is in the unfolded state, the width of the surface of the molding structure 430 in the first direction may be less than the width of a surface in the second direction.

In an embodiment, the first edge frame 241 and the second edge frame 242 respectively connected to the first housing 210 and the second housing 220 to surround at least a portion of an edge area of the display module 250 may be further included.

In an embodiment, a widthwise distance between the first edge frame 241 and an end portion of the side surface 433 of the molding structure 430 in the first direction when the electronic device 200 is in a folded state may be less than a widthwise distance between the first edge frame 241 and the end portion of the side surface 433 of the molding structure 430 in the first direction when the electronic device 200 is in the unfolded state.

In an embodiment, when the electronic device 200 is in the unfolded state, the side surface 433 of the molding structure 430 may be inclined with respect to the first direction, and when the electronic device 200 is in the folded state, the side surface 433 of the molding structure 430 may be parallel to the first direction.

In an embodiment, when static electricity is generated in an edge area of the display module 250, the static electricity may be discharged to the first housing 210 or the second housing 220 through the display module 250, the molding structure 430, and the conductive member 440.

In an embodiment, the conductive member 440 may be attached to the surface of the molding structure 430 in the second direction.

In an embodiment, the bonding member 450 filling a space between the front portion 254 of the display module 250 and the first extension 255 and including a non-conductive material may be further included.

In an embodiment, the molding structure 430 may include the molding body 434 including a non-conductive material, and the conductive coat 435 coated on an outer surface of the molding body 434.

In an embodiment, the surface of the molding structure 430 in the first direction may be positioned on a same plane as the outermost layer of the front portion 254 of the display module 250 in the first direction.

In an embodiment, a cross-section of the molding structure 430 may include a trapezoidal shape or a parallelogram shape.

In an embodiment, the thickness of the molding structure 430 may be greater than the thickness of the first extension 255 of the display module 250.

In an embodiment, the display module 250 applied to the electronic device 200 may include the front portion 254 disposed in the first direction, the first extension 255 extending from an end portion of the front portion 254 and bent toward the second direction which is opposite to the first direction, the second extension 256 extending from the first extension 255 and positioned in the rear direction of the front portion 254, and the molding structure 430 formed to surround at least the first extension 255 of the display module 250 and including a conductive material. The surface of the molding structure 430 in the first direction may be positioned at the same height as or higher than an outermost layer of the front portion 254 of the display module 250 in the first direction.

In an embodiment, the molding structure 430 may be formed through a molding process using a mold having a shape which surrounds the first extension 255 of the display module 250.

In an embodiment, the molding structure 430 may be elastically deformable.

In an embodiment, while the display module 250 is in an unfolded state, the width of the surface of the molding structure 430 in the first direction may be less than the width of a surface in the second direction.

In an embodiment, the electronic device 200 may include the first housing 210 and the second housing 220 foldably connected to each other, the display module 250 including a front portion 254 disposed on the first housing 210 and the second housing 220 and disposed in the first direction, the first extension 255 extending from an end portion of the front portion 254 and bent toward the second direction which is opposite to the first direction, and the second extension 256 extending from the first extension 255 and positioned in the rear direction of the front portion 254, the molding structure 430 formed to surround at least the first extension 255 of the display module 250 and including a conductive material, and the conductive member 440 electrically connecting the molding structure 430 to the first housing 210 or the second housing 220. The surface of the molding structure 430 in the first direction may be positioned at the same height as or higher than an outermost layer of the front portion 254 of the display module 250 in the first direction. The molding structure 430 may be formed through a molding process using a mold having a shape which surrounds the first extension 255 of the display module 250. In a process of folding the electronic device 200 in an unfolded state, the molding structure 430 may be elastically deformable. The width of the surface of the molding structure 430 in the first direction may be less than the width of the surface 432 in the second direction. When static electricity is generated in an edge area of the display module 250, the static electricity may be discharged to the first housing 210 or the second housing 220 through the display module 250, the molding structure 430, and the conductive member 440.

## Claims

1. An electronic device (200) comprising:
a first housing (210) and a second housing (220) foldably connected to each other;
a display module (250) comprising a front portion (254) disposed on the first housing (210) and the second housing (220) and disposed in a first direction, a first extension (255) extending from an end portion of the front portion (254) and bent toward a second direction that is opposite to the first direction, and a second extension (256) extending from the first extension (255) and positioned in a rear direction of the front portion (254);
a molding structure (430) formed to surround at least the first extension (255) of the display module (250) and comprising a conductive material; and
a conductive member (440) electrically connecting the molding structure (430) to the first housing (210) or the second housing (220),
wherein a surface (431) of the molding structure (430) in the first direction is positioned at a same height as or higher than an outermost layer of the front portion (254) of the display module (250) in the first direction.

2. The electronic device (200) of claim 1,
wherein the molding structure (430) is formed to fill a space adjacent to the first extension (255) of the display module (250).

3. The electronic device (200) of claim 1 or 2,
wherein the molding structure (430) is formed through a molding process using a mold having a shape that surrounds the first extension (255) of the display module (250).

4. The electronic device (200) of one of claims 1 to 3,
wherein, in a process of folding the electronic device (200) in an unfolded state, the molding structure (430) is elastically deformable.

5. The electronic device (200) of one of claims 1 to 4,
wherein, while the electronic device (200) is in the unfolded state, a width of the surface (431) of the molding structure (430) in the first direction is less than a width of a surface (432) in the second direction.

6. The electronic device (200) of one of claims 1 to 5, further comprising:
a first edge frame (241) and a second edge frame (242) respectively connected to the first housing (210) and the second housing (220) to surround at least a portion of an edge area of the display module (250).

7. The electronic device (200) of one of claims 1 to 6,
wherein a widthwise distance between the first edge frame (241) and an end portion of a side surface (433) of the molding structure (430) in the first direction when the electronic device (200) is in a folded state is less than a widthwise distance between the first edge frame (241) and the end portion of the side surface (433) of the molding structure (430) in the first direction when the electronic device (200) is in the unfolded state.

8. The electronic device (200) of one of claims 1 to 7, wherein, when the electronic device (200) is in the unfolded state, the side surface (433) of the molding structure (430) is inclined with respect to the first direction, and when the electronic device (200) is in the folded state, the side surface (433) of the molding structure (430) is parallel to the first direction.

9. The electronic device (200) of one of claims 1 to 8,
wherein, when static electricity is generated in an edge area of the display module (250), the static electricity is discharged to the first housing (210) or the second housing (220) through the display module (250), the molding structure (430), and the conductive member (440).

10. The electronic device (200) of one of claims 1 to 9, wherein the conductive member (440) is attached to the surface (432) of the molding structure (430) in the second direction.

11. The electronic device (200) of one of claims 1 to 10, further comprising:
a bonding member (450) filling a space between the front portion 254 of the display module (250) and the first extension (255) and comprising a non-conductive material.

12. The electronic device (200) of one of claims 1 to 11, wherein the molding structure (430) comprises a molding body (434) comprising a non-conductive material, and a conductive coat (435) coated on an outer surface of the molding body (434).

13. The electronic device (200) of one of claims 1 to 12, wherein the surface (431) of the molding structure (430) in the first direction is positioned on a same plane as the outermost layer of the front portion (254) of the display module (250) in the first direction.

14. The electronic device (200) of one of claims 1 to 13, wherein a cross-section of the molding structure (430) comprises a trapezoidal shape or a parallelogram shape.

15. The electronic device (200) of one of claims 1 to 14, wherein a thickness of the molding structure (430) is greater than a thickness of the first extension (255) of the display module (250).
